# EUROPÄISCHE PATENTANMELDUNG

(11) **EP 0 905 905 A1**
(43) Veröffentlichungstag der Anmeldung: **31.03.1999**
(21) Anmeldenummer: 98116969.1
(22) Anmeldetag: 08.09.1998
(51) Int. Cl.: H03K 19/173

(54) **Logikgatter**

(30) Priorität: 30.09.1997 DE 19743261
(71) Anmelder: SIEMENS AKTIENGESELLSCHAFT, 80333 München (DE)
(72) Erfinder: Johnson, Bret, 81737 München (DE); Schneider, Ralf, 81925 München (DE)

(57) **Zusammenfassung**

Es wird ein Logikgatter vorgestellt, das bei minimalem Schaltungsaufwand in Abhängigkeit von zwei Steuersignalen (L0, L1) sowohl als Inverter wie auch als NAND-Gatter wie auch als NOR-Gatter betreibbar ist.

## Beschreibung

Die vorliegende Erfindung betrifft ein Logikgatter.

Logikgatter sind wichtige Bestandteile digitaler Schaltungen. Zur Realisierung verschiedener Logikfunktionen muß jeweils ein eigenes Logikgatter geschaffen werden, das dann ausschließlich die jeweilige Logikfunktion erfüllt. Von Nachteil ist dabei, daß für die verschiedenen Logikfunktionen verschiedene Gatter notwendig sind.

Die US 5,309,043 zeigt ein Logikgatter mit Nand- bzw NorAusgang.

Aufgabe der vorliegenden Erfindung ist es, für eine gegebene Anzahl verschiedener Logikfunktionen eine möglichst geringe Anzahl von Logikgattern Zu benötigen.

Diese Aufgabe wird gelöst mit den Merkmalen des Patentanspruches 1.

Das erfindungsgemäße Logikgatter hat den besonderen Vorteil, daß es sowohl als Inverter wie auch als NOR-Gatter wie auch als NAND-Gatter betreibbar ist. Wollte man die funktionellen Möglichkeiten des erfindungsgemäßen Logikgatters mit üblichen, bekannten Logikgattern realisieren, so müßte man entweder ein OR-Gatter mit einem ersten Eingang eines NAND-Gatters verbinden oder ein AND-Gatter mit einem ersten Eingang eines NOR-Gatters. In beiden Fällen träte im Betrieb eine Laufzeitverzögerung (Zeitdauer zwischen Anlegen der Eingangssignale und Auftreten des Ausgangssignales) auf, die zwei sogenannten Gatterlaufzeiten entspricht. Beim erfindungsgemäßen Logikgatter hingegen beträgt diese Laufzeitverzögerung nur eine einzige Gatterlaufzeit.

Die Erfindung wird nachstehend anhand einer Figur näher erläutert: Zwischen zwei Versorgungspotentialen VDD und VSS sind parallel zueinander zwei Schaltungszweige vorgesehen.

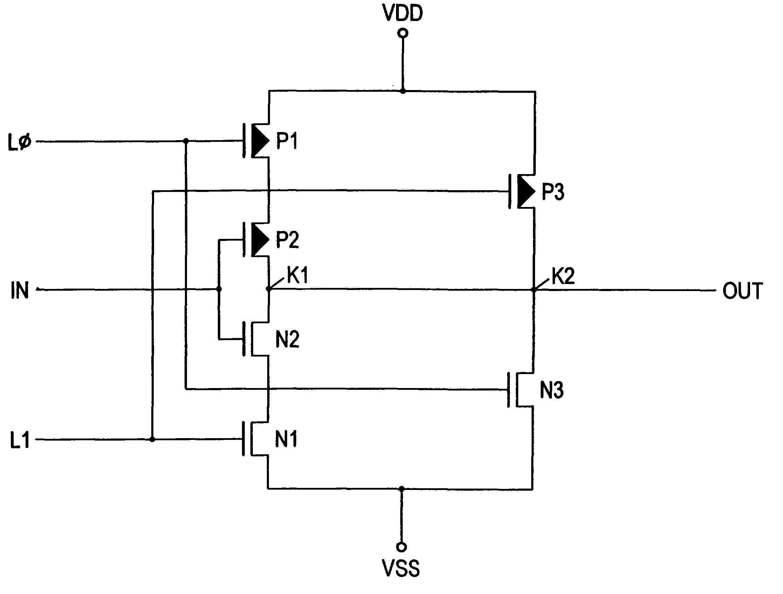

Der eine Schaltungszweig enthält einen ersten (P1) und einen zweiten Transistor P2 eines ersten Kanaltyps sowie einen ersten (N1) und einen zweiten Transistor N2 eines zweiten Kanaltyps. Diese vier Transistoren P1, P2, N1, N2 sind in der Weise in Serie zueinander angeordnet, daß jeder der beiden Transistoren P1, P2 des ersten Kanaltyps mit dem jeweils anderen der beiden Transistoren P1, P2 dieses ersten Kanaltyps verbunden ist, daß jeder der beiden Transistoren N1, N2 des zweiten Kanaltyps mit dem jeweils anderen der beiden Transistoren N1, N2 dieses zweiten Kanaltyps verbunden ist und daß einer der beiden Transistoren P1, P2 des ersten Kanaltyps mit einem der beiden Transistoren N1, N2 des zweiten Kanaltyps verbunden ist. In der Figur sind dies die zweiten Transistoren P2 und N2. Zwischen denjenigen Transistoren, die miteinander verbunden sind und die vom unterschiedlichen Kanaltyp sind (in der Figur: zwischen den Transistoren P2 und N2) ist ein erster Schaltungsknoten K1 ausgebildet.

Der andere Schaltungszweig enthält in Serie zueinander einen dritten Transistor P3 vom ersten Kanaltyp und einen dritten Transistor N3 vom zweiten Kanaltyp. Sie sind mittels eines zweiten Schaltungsknoten K2 miteinander verbunden.

Die beiden Schaltungsknoten K1, K2 sind miteinander verbunden. An ihnen entsteht im Betrieb ein Ausgangssignal OUT des Logikgatters. Die beiden zweiten Transistoren P2, N2 sind an ihrem Gate mittels eines Eingangssignals IN steuerbar. Der erste Transistor P1 vom ersten Kanaltyp und der dritte Transistor N3 vom zweiten Kanaltyp sind an ihrem Gate mittels eines ersten Steuersignals L0 steuerbar. Der erste Transistor N1 vom zweiten Kanaltyp und der dritte Transistor P3 vom ersten Kanaltyp sind an ihrem Gate mittels eines zweiten Steuersignals L1 steuerbar.

Mit dieser Anordnung von Transistoren und Signalen läßt sich das Logikgatter sowohl als Inverter wie auch als NOR-Gatter wie auch als NAND-Gatter betreiben. Dies geschieht folgendermaßen (sogenannte positive Logik angenommen):

Wenn das erste Steuersignal L0 einen niedrigen Logikpegel (sogenannte "0") aufweist und das zweite Steuersignal L1 einen hohen Logikpegel (sogenannte "1"), erscheint als Ausgangssignal OUT das Eingangssignal IN in invertierte Form, das heißt das Logikgatter arbeitet bezüglich des Eingangssignals IN als Inverter.

Wenn das erste Steuersignal L0 einen niedrigen Logikpegel aufweist, erscheint als Ausgangssignal OUT das Ergebnis einer NAND-Verknüpfung des Eingangssignals IN mit dem zweiten Steinersignal L1, das heißt, das Logikgatter arbeitet als NAND-Gatter. Wenn das zweite Steuersignal L1 einen hohen Logikpegel aufweist, erscheint als Ausgangssignal OUT das Ergebnis einer NOR-Verknüpfung des Eingangssignals IN mit dem ersten Steuersignal L0, das heißt, das Logikgatter arbeitet als NOR-Gatter.

Das erfindungsgemäße Logikgatter ist also bei minimalem Schaltungs- und Platzaufwand auf drei verschiedene Arten einsetzbar. Zu beachten ist lediglich, daß nicht gleichzeitig das erste Steuersignal L0 einen hohen Logikpegel aufweisen darf und das zweite Steuersignal L1 einen niedrigen Logikpegel. In diesem Fall entstünde nämlich ein Kurzschluß zwischen den beiden Versorgungspotentialen VDD, VSS über die dritten Transistoren P3, N3, da beide dritte Transistoren P3, N3 gleichzeitig durchgeschaltet würden. Dieser Kurzschlußfall ist jedoch dadurch umgehbar, daß die beiden dritten Transistoren P3, N3 so ausgelegt sind, daß sie auch im elektrisch leitenden Zustand genügend hochohmig leitend sind, so daß kein unzulässig hoher Strom fließen kann.

## Patentansprüche

1. Logikgatter mit folgenden Merkmalen:
- ein ersten (P1) und ein zweiter Transistor (P2) von einem ersten Kanaltyp sowie ein erster (N1) und ein zweiter Transistor (N2) von einem zweiten Kanaltyp sind in Serie zueinander zwischen einem ersten (VDD) und einem zweiten Versorgungspotential (VSS) angeordnet,
- ein dritter Transistor (P3) vom ersten Kanaltyp und ein dritter Transistor (N3) vom zweiten Kanaltyp sind in Serie zueinander parallel zu der Serienschaltung der ersten (P1, N1) und zweiten Transistoren (P2, N2) beider Kanaltypen angeordnet,
- die zweiten Transistoren (P2, N2) beider Kanaltypen sind mittels eines Eingangssignals (IN) steuerbar,
- der erste Transistor (P1) des ersten Kanaltyps und der dritte Transistor (N3) des zweiten Kanaltyps sind mittels eines ersten Steuersignals (L0) steuerbar,
- der erste Transistor (N1) des zweiten Kanaltyps und der dritte Transistor (P3) des ersten Kanaltyps sind mittels eines zweiten Steuersignals (L1) steuerbar,
- ein zwischen den zweiten Transistor (P2, N2) beider Kanaltypen angeordneter erster Schaltungsknoten (K1) und ein zwischen den dritten Transistoren (P3, N3) beider Kanaltypen angeordneter zweiter Schaltungsknoten (K2) sind miteinander verbunden,
- die beiden Schaltungsknoten (K1, K2) führen im Betrieb ein Ausgangssignal (OUT) des Logikgatters.
